# EUROPEAN PATENT APPLICATION

(11) **EP 4 531 088 A1**
(43) Date of publication of application: **02.04.2025**
(21) Application number: 23200703.9
(22) Date of filing: 29.09.2023
(51) Int. Cl.: H01L 21/822, H01L 21/8238, H01L 27/06, H01L 27/092, H01L 29/06

(54) **METHOD FOR PROCESSING A CFET DEVICE WITH AN EMBEDDED SIDE RAIL ROUTING**

(71) Applicant: Imec VZW, 3001 Leuven (BE)
(72) Inventor: Chan, Boon Teik, 3012 Wilsele (BE); Ryckaert, Julien, 1030 Schaerbeek (BE)
(74) Representative: Roth, Sebastian

(57) **Abstract**

The disclosure relates to a method for processing a CFET device (10). The method comprises the steps of: forming a fin structure (23) comprising a first layer stack (23a) and a second layer stack (23b) above the first layer stack (23a); forming a trench (26) in a buffer layer (25) on one side of the fin structure (23), wherein the trench runs (26) in parallel to the fin structure (23); filling a first section of the trench (26) at least partially with a first metal layer (15), wherein the first metal layer (15) is arranged at a level of the first layer stack (23a); and filling a second section of the trench (26) at least partially with a second metal layer (16), wherein the second metal layer (16) is arranged at a level of the second layer stack (23b); wherein the first metal layer (15) and the second metal layer (16) are arranged shifted to each other in a direction along the length of the trench (26).

## Description

### TECHNICAL FIELD

The present disclosure refers to a method for processing a complementary field effect transistor (CFET) device. In particular, the disclosure presents an efficient processing of a CFET device with a side routing architecture.

### BACKGROUND

In a CFET, different transistor structures, particularly NMOS and PMOS transistors, may be stacked on top of each other. Compared, for example, to a nanosheet device, which comprises NMOS and PMOS transistors arranged side by side with a spacing in between them. The stacking of the transistor structures enables increasing an effective channel width.

In many conventional CFET designs, a bottom device epi (e.g., a source or drain of a bottom transistor) should be electrically connected to a top device epi (e.g., a source or drain of a top transistor). However, processing routing lines between the two CFET tiers (bottom and top) to enable this connection is challenging.

For instance, the top and bottom device could be electrically connected via an electrical line on one side of the CFET (side routing). However, it is difficult to fabricate such a side routing connection, which electrically contacts the top and bottom transistor device, without damaging other components of the CFET, such as the top epi, a bottom MoA layer or an isolation of the CFET.

Furthermore, it is challenging to laterally contact the top and bottom transistor structure with the side routing line without having a large contact resistance.

### SUMMARY

Thus, it is an objective to provide an improved method for processing a CFET device. In particular, the above-mentioned disadvantages should be avoided.

The objective is achieved by the embodiments provided in the enclosed independent claims. Advantageous implementations of the embodiments of the invention are further defined in the dependent claims.

A first aspect of this disclosure provides a method for processing a complementary field effect transistor (CFET) device. The method comprises the steps of: forming a fin structure comprising a first layer stack and a second layer stack above the first layer stack; forming a trench in a buffer layer on one side of the fin structure, wherein the trench runs in parallel to the fin structure; filling a first section of the trench at least partially with a first metal layer, wherein the first metal layer is arranged at a level of the first layer stack; and filling a second section of the trench at least partially with a second metal layer, wherein the second metal layer is arranged at a level of the second layer stack; wherein the first metal layer and the second metal layer are arranged shifted to each other in a direction along the length of the trench.

This achieves the advantage that a CFET device with an embedded side routing architecture can be processed efficiently. In particular, this approach is advantageous compared to a formation of the side routing by means of high aspect ratio (i.e., deep) vias. The first metal layer may form a side rail (or side routing) structure of a bottom transistor structure of the CFET device and the second metal layer may form a side rail (or side routing) structure of a top transistor structure of the CFET device.

In particular, the trench is formed at a determined distance to the fin structure, such that there is a gap between the trench and the fin structure.

The first metal layer can be a MoAB layer and the second metal layer can be a MoAT layer.

The buffer layer can be an oxide layer, e.g. SiO₂.

Hereby, processing the CFET device may refer to fabricating or manufacturing the CFET device.

In an embodiment, the first layer stack comprises at least one channel of a first transistor structure of the CFET device, and the second layer stack comprises at least one channel of a second transistor structure of the CFET device.

The first (or bottom) transistor structure can be arranged in a first tier (or level) and the second (or top) transistor structure can be arranged in a second tier (or level) of the CFET device, wherein the second tier is arranged above the first tier. This may result in stacked transistor structures of the CFET device. However, two particular transistor structures of the CFET device - one in the first tier and the other one in the second tier - do not have to be arranged directly above each other (with respect to a stacking direction of the CFET device, typically the "vertical" direction in this disclosure), but may also be arranged indirectly above each other, which means that they may be offset in a "horizontal" direction, which is perpendicular to the "vertical" or stacking direction. The CFET device may comprise further transistor structures or other elements, which could respectively be directly above or beneath the first and second transistor structure.

For instance, the first transistor structure and the second transistor structure can form a CFET cell. The CFET device can comprise one or more CFET cells or parts thereof.

Notably, in this disclosure the terms "below" and "above", "bottom" and "top", or similar terms are to be interpreted relative to each other. In particular, these terms describe opposite sides of the CFET device, or opposite side of any element of the CFET device. The terms may describe a relationship of elements (e.g., transistor structures, signal routing lines, power rails, etc.) of the CFET device along the direction of stacking of the tiers (or levels) of the CFET device. The stacking direction may thus align with the arrangement of the two tiers (or even more than two tiers) of the CFET device. That is, the two or more tiers (or levels), which are arranged above each other, are arranged one after the other along a certain direction (the stacking direction).

A transistor structure in this disclosure may be or may comprise a transistor, for example a field effect transistor (FET), or may be or may comprise a more complex semiconductor-based structure, which functions like a transistor. For instance, the semiconductor-based structure may be a nanosheet structure, a fin structure, or a forksheet structure, for example, provided with a gate partly wrapping around or fully wrapping around channel portions. The latter may be for instance a gate-all-around structure.

The transistor structures of the CFET device of the first aspect may be NMOS and PMOS transistor structures. For instance, the first transistor structure may be an NMOS transistor structure and the second transistor structure a PMOS transistor structure, or vice versa

In an embodiment, the method comprises the further step of: forming a first horizontal contact structure which electrically connects the first metal layer with a first source or drain terminal that is arranged on at least one side of the first layer stack.

This achieves the advantage that a lateral contact from the (bottom) signal routing line to the (bottom) source or drain terminal of the first transistor structure can be established. In particular, the first horizontal contact structure and the bottom signal routing line (first metal layer) can be formed simultaneously or in successive steps. Hereby, "lateral" may be with respect to the signal routing line (and e.g. not with respect to the source or drain terminal).

For instance, the first source or drain (S/D) terminal is arranged on or around the channel layer(s) of the first layer stack. In particular, the first source or drain terminal is arranged to electrically contact the channel layer(s) of the first layer stack.

In an embodiment, the first source or drain terminal is formed by means of an epitaxial growth process prior to the formation of the first horizontal contact structure.

In an embodiment, the first horizontal contact structure contacts the first source or drain terminal from the top.

This achieves the advantage that a larger contact surface between the first horizontal contact structure and the first source or drain terminal is formed which reduces the contact resistivity.

In an embodiment, the method comprises the further step of: forming a second horizontal contact structure which electrically connects the second metal layer with a second source or drain terminal that is arranged on at least one side of the second layer stack.

This achieves the advantage that a lateral contact from the (top) signal routing line to the (top) source or drain terminal of the second transistor structure can be established. In particular, the second horizontal contact structure and the top signal routing line (second metal layer) can be formed simultaneously or in successive steps. Hereby, "lateral" may be with respect to the signal routing line (and e.g. not with respect to the source or drain terminal).

For instance, the second source or drain terminal is arranged on or around the channel layer(s) of the second layer stack. In particular, the second source or drain terminal is arranged to electrically contact the channel layer(s) of the second layer stack.

In an embodiment, the second source or drain terminal is formed by means of an epitaxial growth process prior to the formation of the second horizontal contact structure.

In an embodiment, the second horizontal contact structure contacts the second source or drain terminal from the top.

This achieves the advantage that a larger contact surface between the second horizontal contact structure and the second source or drain terminal is formed which reduces the contact resistivity.

In an embodiment, the trench is formed by: forming a dummy fin structure next to the fin structure, wherein the dummy fin structure runs in parallel to the fin structure; filling an area on both sides of the dummy fin structure with the buffer layer; and at least partially removing the dummy fin structure.

This achieves the advantage that the fabrication of the side routing rails (first and second metal layers), in particular their alignment to the fin structure and the channels therein, can be facilitated. In this way, a "self-aligned" 1D side rail routing can be realized.

In particular, the dummy fin structure is formed at a determined distance to the fin structure, such that there is a gap between the dummy fin structure and the fin structure

For instance, the dummy fin structure can be fully removed or partially recessed.

In an embodiment, in a first removal step, a portion of the dummy fin structure is removed to expose the first section of the trench; and, in a second removal step, a further portion of the dummy fin structure is removed to expose the second section of the trench.

In an embodiment, the first metal layer is deposited in the first section of the trench prior to the second removal step.

This achieves the advantage that the first metal layer (bottom side rail structure) can be fabricated efficiently.

In an embodiment, the trench is formed by etching into the buffer layer with at least two separate etching steps; wherein, in a first etching step, a portion of the buffer layer is removed to expose the first section of the trench; and, in a second etching step, a further portion of the buffer layer is removed to expose the second section of the trench.

This achieves the advantage that the fabrication of the side routing rails (first and second metal layers) can be facilitated.

In an embodiment, the first metal layer is deposited in the first section of the trench prior to the second etching step.

This achieves the advantage that the first metal layer (bottom side rail structure) can be fabricated efficiently.

In an embodiment, the method comprises the further step of: forming a metal via structure in the trench which electrically connects the first metal layer with the second metal layer.

In this way, an electrical contact between the bottom and the top side rail structures (first and second metal layers) can be established. Thus, a side rail routing structure can be generated which spans both CFET levels (or tiers) and connects a source or drain terminal of the first (bottom) transistor structure with a source or drain terminal of the second (top) transistor structure of the CFET device.

At least a portion of the second metal layer can be arranged directly above the first metal layer. Thus, the metal via structure can be a vertical metal via.

In an embodiment, the buffer layer is a silicon dioxide (SiO₂) layer, in particular a FCVD (filament chemical vapor deposition) SiO₂ layer. The buffer layer can also be formed by a bottom up dielectric fill.

A second aspect of this disclosure provides a CFET device obtainable by the method according to the first aspect of this disclosure.

### BRIEF DESCRIPTION OF THE DRAWINGS

The above described aspects and implementations are explained in the following description of embodiments with respect to the enclosed drawings:
- FIGS. 1A-F: show a process flow of a method for processing a CFET device according to an embodiment;
- FIGS. 2A-B: show different views of a CFET device according to an embodiment;
- FIG. 3: shows a perspective view of a CFET device according to an embodiment;
- FIGS. 4A-BB: show a process flow of a method for processing a CFET device according to an embodiment; and
- FIGS. 5A-H: show a process flow of a method for processing a CFET device according to an embodiment.

### DETAILED DESCRIPTION OF EMBODIMENTS

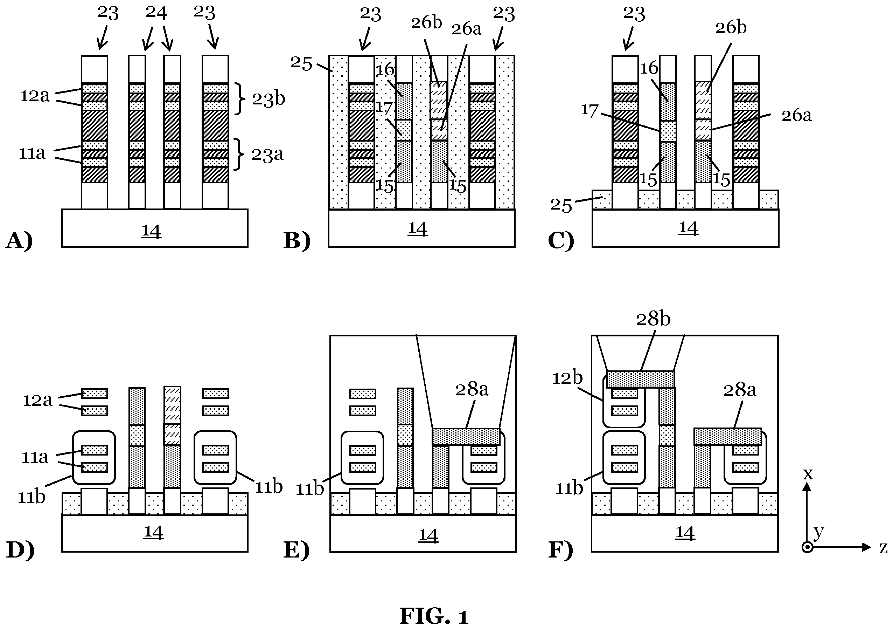

FIGS. 1A-F show a process flow of a method for processing a CFET device according to an embodiment. FIGS. 1A-F thereby show cross-section views through an x-z plane (as indicated by the Cartesian coordinate system), which is perpendicular to a channel direction (y-direction) of the CFET device.

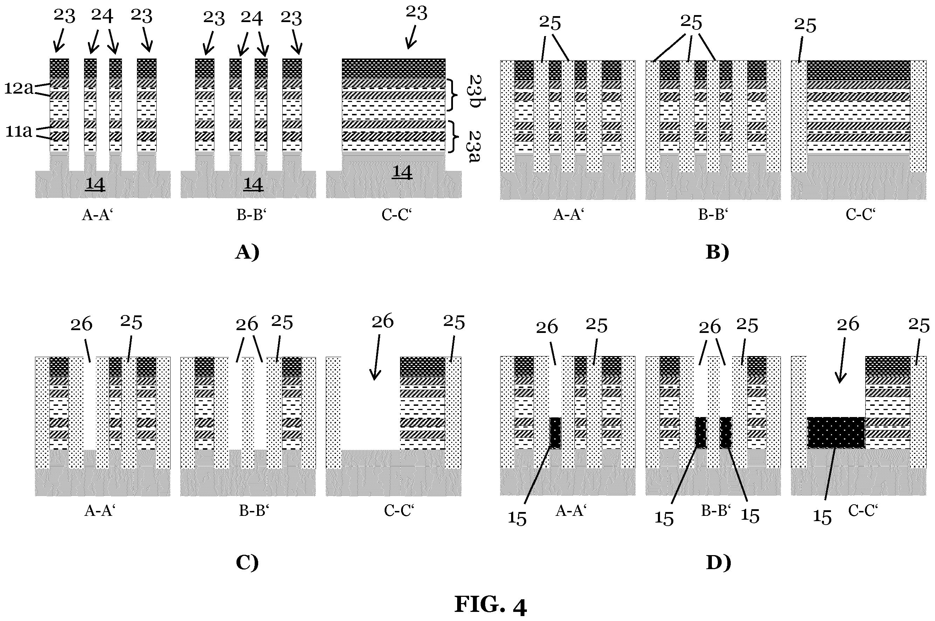

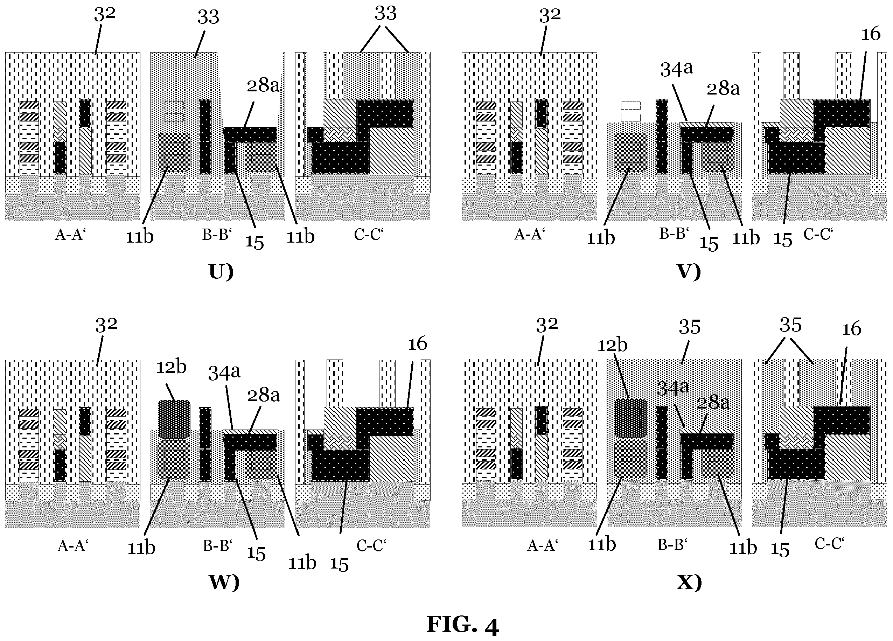

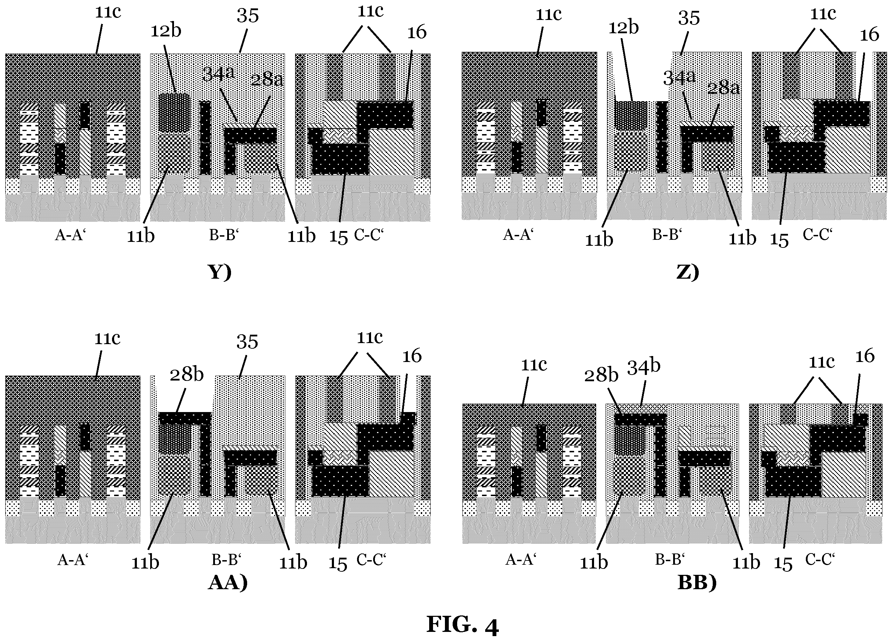

In the example shown in FIGS. 1A-F (as well as FIGS. 4A-BB and 5A-H), two structures with the same basic elements are processed side by side, wherein the structures are arranged offset or staggered along a direction of the channel. These two structures can form different CFET devices or different CFET cells or components of a single CFET device. A CFET cell may be a unit cell of the CFET device, wherein unit cell means that the CFET cell could be repeated one or more times in the CFET device. In particular, identical elements of the two structures can be formed simultaneously. In the following, processing steps that can be identical for both structures are usually described with reference to only one of the structures.

As shown in FIG. 1A, the method comprises a forming of a fin structure 23 comprising a first layer stack 23a and a second layer stack 23b above the first layer stack 23a.

The first layer stack 23a may comprise at least one channel 11a of a first transistor structure of the CFET device and the second layer stack 23b may comprise at least one channel 12a of a second transistor structure of the CFET device. For instance, the first transistor structure is a bottom transistor structure and the second transistor structure is a top transistor structure of the CFET device. The bottom transistor structure can be a NMOS and the top transistor structure can be a PMOS, or vice versa.

The first and second layer stack 23a, 23b can be arranged directly on top of each other. A dielectric separation layer stack (e.g., middle dielectric isolation, MDI) can be arranged between the first and second layer stack 23a, 23b. However, the dielectric separation layer stack can also be a part of the first or the second layer stack 23a, 23b.

As shown in Fig. 1A, the method may further comprise forming a dummy fin structure 24 next to each fin structure 23. The fin structure and the dummy fin structure can be formed at the same time by patterning a substrate comprising the first and second layer stack 23a, 23b, e.g., by means of 1D EUV lithography and subsequent etching, and thereby exposing the fin structure 23 and dummy fin structure 24. Each dummy fin structure 24 can act as placeholder structure for a later side rail structure. Thus, the dummy fin structure(s) 24 can enable a 1D self-aligned side rail routing patterning.

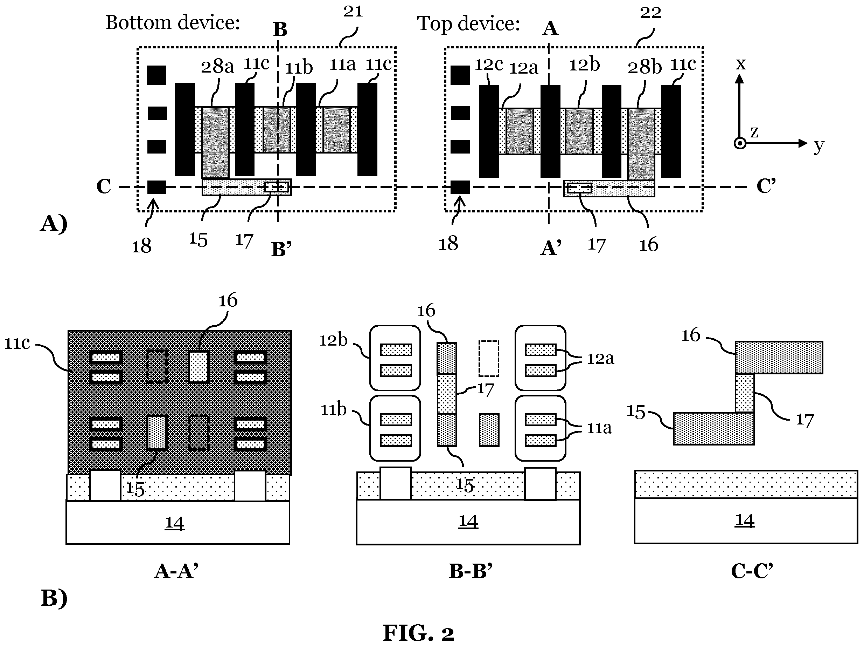

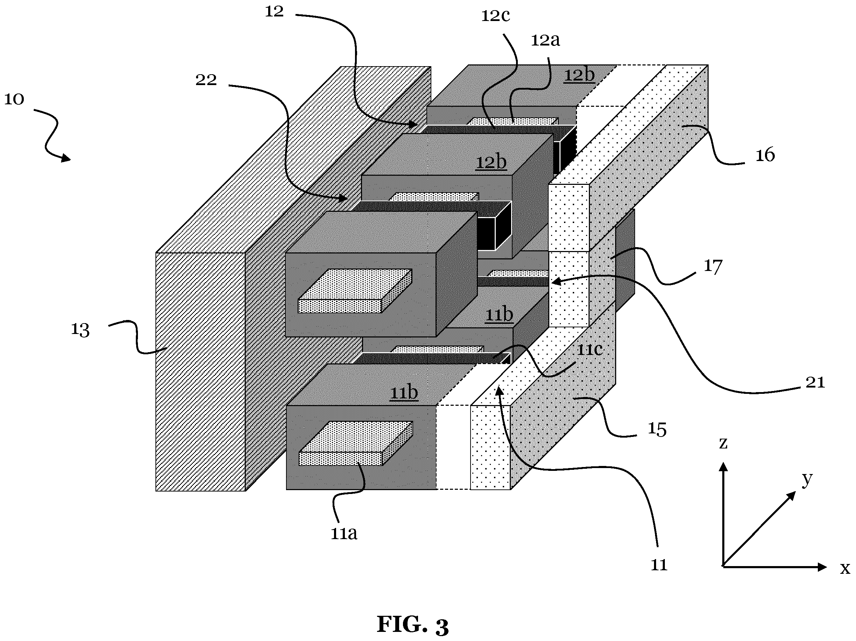

As shown in FIG. 1B, the method further comprises forming a trench in a buffer layer 25 on one side (or both sides) of the fin structure 23, wherein the trench runs in parallel to the fin structure. A first section of the trench is at least partially filled with a first metal layer 15, wherein the first metal layer 15 is arranged at a level of the first layer stack 23a; and a second section of the trench is at least partially filled with a second metal layer 16, wherein the second metal layer 16 is arranged at a level of the second layer stack 23b. Thereby, the first metal layer 15 and the second metal layer 16 are arranged shifted to each other in a direction along the length of the trench. This arrangement of the metal layers can for example be seen in FIGS. 2A-B and FIG. 3 which show different cross-sectional and perspective views of a resulting CFET device.

In the example shown in FIG. 1B, each trench is formed by selectively removing (at least partially) a dummy fin structure 24, such that the buffer layer 25 remains as a spacer next to the fin structure 23. In this way, a self-aligned block (SAB) for active patterning can be realized. The removal of the dummy fin structure 24 can be realized by a suitable etching process.

The buffer layer 25 can be a SiO₂ layer, in particular SiO₂ layer deposited by (hot) filament chemical vapor deposition (FCVD).

The method may further comprise forming a metal via structure 17 in the trench which electrically connects the first metal layer 15 with the second metal layer 16 (shown for the metal layers 15, 16 in the left trench in FIG. 1B). The first and second metal layers 15, 16 as well as the metal via structure 17 can form a side rail structure (also: side routing structure) of the CFET device. For instance, the first metal layer 15 is arranged in a first level (or tier) of the CFET device and the second metal layer 16 is arranged in a second level or tier of the CFET device. The first metal layer 15 can be a MoAB layer and the second metal layer 16 can be a MoAT layer.

The first and the second metal layer 15, 16 are arranged shifted along the direction of the trench. However, a section of these channels 15, 16 can be arranged above each other and electrically connected by the vertical metal via structure 17, as shown for the left side rail structure in FIG. 1B. In the right side rail structure in FIG. 1B, the second metal layer is not arranged above the first metal layer (in the depicted cross-sectional plane). The first metal layer can be covered by a vertical isolation 26a and a SiO₂ layer 26b in this region.

In a next step shown in FIG. 1C, the buffer layer 25 can be at least partially recessed to expose the fin structure 23 and side rail structures.

Subsequently, as shown in FIG. 1D, a first source or drain terminal 11b can be formed on at least one side of the first layer stack 23a. In particular, the first source or drain terminal 11b is arranged to electrically contact the channel(s) 11a of the first layer stack 23a. For instance, the source or drain terminal 11b can be formed by means of an epitaxial growth process on or around the channel(s) 11a.

In a further step, shown in FIG. 1E, a first horizontal contact structure 28a can be formed which electrically connects the first metal layer 15 with the first source or drain terminal 11b. The first horizontal contact structure may contact the first source or drain terminal 11b from the top. This provides the advantage of a large contact area and, thus, low contact resistance. In the cross-sectional plane shown in FIG. 1E, this horizontal contact structure 28a is shown for the right side rail structure and fin structure. A similar horizontal contact structure 28a can be formed for the left side rail structure and fin structure 23 in a different plane along the channels 11a, 12a.

The first horizontal contact structure 28a can be an extended MoA structure which is arranged to bridge the bottom epi (source or drain terminal 11b) and side rail bottom structure (first metal layer 15). In this way, a dual MoA module can be formed. After formation of the first horizontal contact structure 28, a metal recess and vertical isolation formation can be carried out.

Subsequently, as shown in FIG. 1F, a second source or drain terminal 12b can be formed on at least one side of the second layer stack 23b (e.g., on or around the channel(s) 12a of the second layer stack 23b). In FIG. 1F, the second source or rain terminal 12b is only shown for the left fin structure 23. However, a similar source or train terminal 12b can also be formed for the right fin structure 23 simultaneously. The second source or rain terminal 12b can be formed by an epitaxial growth process.

After forming the second source or drain terminal(s) 12b, a second horizontal contact structure 28b can be formed which contacts the second source or drain terminal 12b from the top. This again provides the advantage of a large contact area and, thus, low contact resistance.

The second horizontal contact structure 28b can be a extended MoT structure or module which is arranged to bridge the top epi (source or drain terminal 12b) and side rail top structure (second metal layer 16). The via structure 17 and the horizontal contact structure 28b are typically arranged shifted to each other along the channel direction (y-direction in FIGS. 1A-F), as e.g. shown in FIG. 2A and FIG. 3.

In particular, with the above method, the side rail routing structure can be formed prior or during a formation of an active source/drain module or during an STI (shallow trench isolation) module and prior to a gate formation (e.g. replacement metal gate module). The "integration" of the side rail structure formation in these (early) processes provides several advantages. For instance, by first forming the side rail structure (first and second metal layer 15, 16), and subsequently forming the bottom source and/or drain terminal(s) 11b (via a bottom epi growth) and the second source or drain terminal(s) 12b (via a top epi growth), damage to the top epi isolation and the bottom metal contacts can be prevented. Such damage could, for instance, occur when first forming the top and bottom source and/or drain terminals 11b, 12b, via epitaxial growth processes, and subsequently starting to form and connect the side rail structures. Furthermore, no complex 2D lithography print is required to form the side rail structures, because all side rail routing (1D) can be done prior or during the active S/D patterning or during STI module. Perpendicular lithography for the vertical contact structures 28a, 28b can be carried out by extending the existing MoAB & MoAT lithography.

FIGS. 2A-B show different views of the processed CFET device according to an embodiment. Thereby, FIG. 2A shows top views of the bottom transistor structure 21 and of the top transistor structure 22 (i.e., their extension in x- and y-directions, as indicated by the Cartesian coordinate system in FIG. 2A) of the CFET device. FIG. 2B shows cross-sectional views of the CFET device as shown in FIG. 2A, wherein the section lines A-A', B-B' and C-C' in FIG. 2A indicate the position of the cross-sections in FIG. 2B.

As shown in FIG. 2A, the top and the bottom transistor structure of the CFET device may each comprise a number of source and/or drain terminals 11b, 12b which are arranged along the channel(s) 11a, 12a alternating with gate terminals 11c. A bottom side rail structure formed by the first metal layer 15 can be electrically connected to a source and/or drain terminal 11b of the bottom transistor structure, and a top side rail structure formed by the second metal layer 16 can be electrically connected to a source and/or drain terminal 12b of the top transistor structure which is arranged offset along the channels 11a, 11b. Furthermore, signal routing lines 18 can be arranged on one end of the CFET device.

As shown in FIG. 2A, both top and bottom side rail structures together with the respective horizontal contact structures 28a, 28 can have an L-shape.

The first and second metal layers 15, 16 can be electrically connected via the vertical metal via structure 17, e.g. in a region where both metal layers 15, 16 overlap. The C-C' cross sectional view in Fig. 2B shows the resulting (two level) side rail structure which connects the first (bottom) transistor structure 21 with the second (top) transistor structure 22 of the CFET device.

As shown in the C-C' cross-sectional view, the first metal layer 15 and the second metal layer 16 are arranged shifted (or displaced) to each other in the direction along the length of the trench (and the channel(s) 11a, 12a). In this way, a bottom source or drain terminal 11b can be electrically connected to a top source or drain terminal 12b which is not direct above the bottom source or drain terminal 12b.

Similar to FIGS. 1A-F, the cross-sectional views in FIG. 2B show two structures (e.g., different CFET devices or CFET cells of a device) with respective side rail structures between them. The side rail structures of both structures can be arranged offset or staggered to each other along the respective channels 11a, 12a. For instance, the B-B' cross section shown in FIG. 2B cuts through both metal layers 15, 16 and the metal via structure 17 of the left side rail structure, but only through the first metal layer 15 of the right side rail structure.

The A-A' cross-sectional view in FIG. 2B shows (a cut along) the gate terminal which may wrap around the channels 11a, 12a of the first and second transistor structure of the CFET device.

FIG. 3 shows a perspective view of the CFET device 10 according to an embodiment.

The CFET device 10 comprises the first transistor structure 21 and the second transistor structure 22. A VSS power rail 13 of the CFET device 10 can be arranged on one side of the first and second transistor structures 21, 22 and the side rail structures 16 can be arranged on an opposite side.

FIGS. 4A-4BB show a process flow of the method for processing the CFET device according to an embodiment. Thereby, each figure shows the A-A', B-B' and C-C' cross-sectional views as indicated in FIG. 2A.

In a first step, shown in FIG. 4A, the fin structure(s) 23 and the dummy fin structure(s) 24 can be formed on a substrate 14 by active nanosheet patterning (e.g., patterning of a nanosheet stack on the substrate 14). Thereby, the dummy fin structures 24 run parallel to the fin structures 23. Each fin structure 23 can comprise the first layer stack 23a and the second layer stack 23b. Each layer stack can comprise a plurality of alternating layers, comprising at least one channel layer (e.g., a Si layer) and at least one dielectric layer. For instance, each layer stack 23a, 23b can comprise alternating Si and SiGe layers. A top layer of the fin structure 23 can be a Si₃N₄ layer. A dielectric separation layer stack (e.g., middle dielectric isolation, MDI) can be arranged between the first and second layer stack 23a, 23b.

Subsequently, the gaps between the fin structure(s) 23 and dummy fin structure(s) 24 can be filled with the buffer layer 25 (e.g. by FCVD SiO₂ deposition), as shown in FIG. 4B, and a subsequent CMP (chemical mechanical polishing) process can be carried out.

Then, as shown in FIG. 4C, a bottom side rail trench patterning can be carried out by partially removing the dummy fin structure 24 to expose the first section of the trench 26. In this way, a self-aligned positioning of the bottom side rail structure can be realized.

The first metal layer 15 can then be deposited in the first section to the trench 26 to be at a level with the first layer stack 23a, as shown in FIG. 4D. This can be carried out by depositing a dielectric liner as well as a metal liner or tungsten in the trench 26. A subsequent metal recess can be carried out to control the metal deposition.

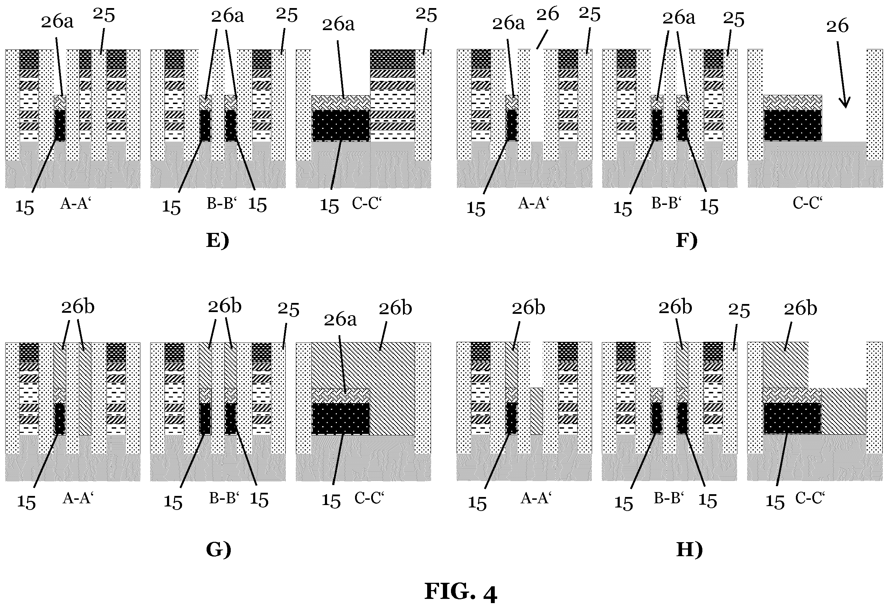

Subsequently, as shown in FIG. 4E, the vertical isolation 26a can be deposited on the first metal layer 15, e.g. by bottom-up filling or by a filling and subsequent etch back step.

Then, the remaining dummy fin structure 24 can be removed (FIG. 4F) and filled with a SiO₂ layer 26b (with SiN layer). After deposition of the SiN layer and SiO₂ layer 26b, a CMP step can be carried out (FIG. 4G).

As shown in FIG. 4H, a top side rail trench patterning can then be carried out by partially removing the SiO₂ layer 26b to expose the second section of the trench 26. In this way, a self-aligned positioning of the top side rail structure can be realized.

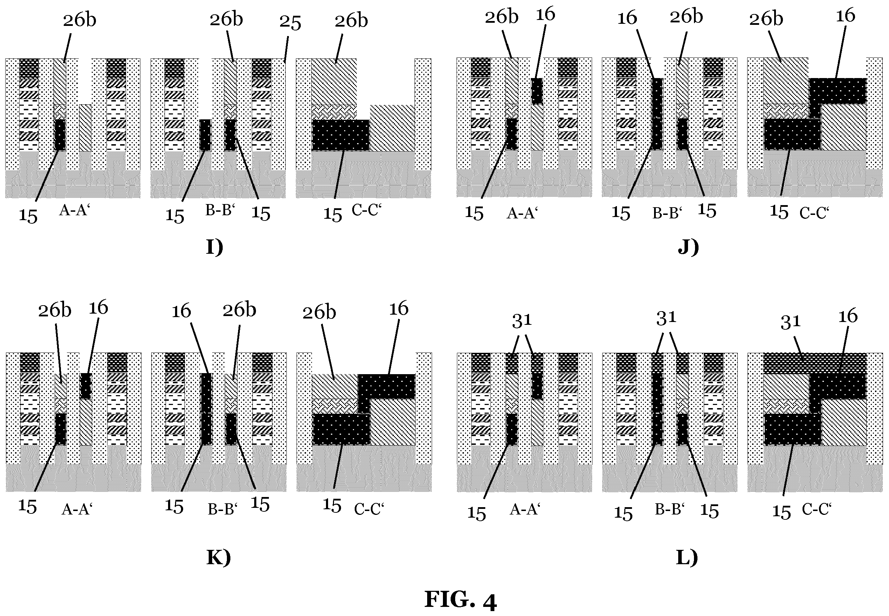

Subsequently, as shown in FIG. 4I, a via patterning can be carried out to expose a via channel between the bottom and top side rail structures (i.e., between the MoaT and MoAB layers). Then, the second metal layer 16 can be deposited in the via channel (by a pre-fill) and the second section of the trench 26 to be at a level with the second layer stack 23b, as shown in FIG. 4J. This top side rail structure metallization can be followed by a metal recess.

In a following step, a recess of the SiO₂ layer 26b can be carried out, as shown in Fig. 4K, and a Si₃N₄ plug 31 can be formed in the remaining section of the trench 26 (FIG. 4L). A CMP step can further be carried out.

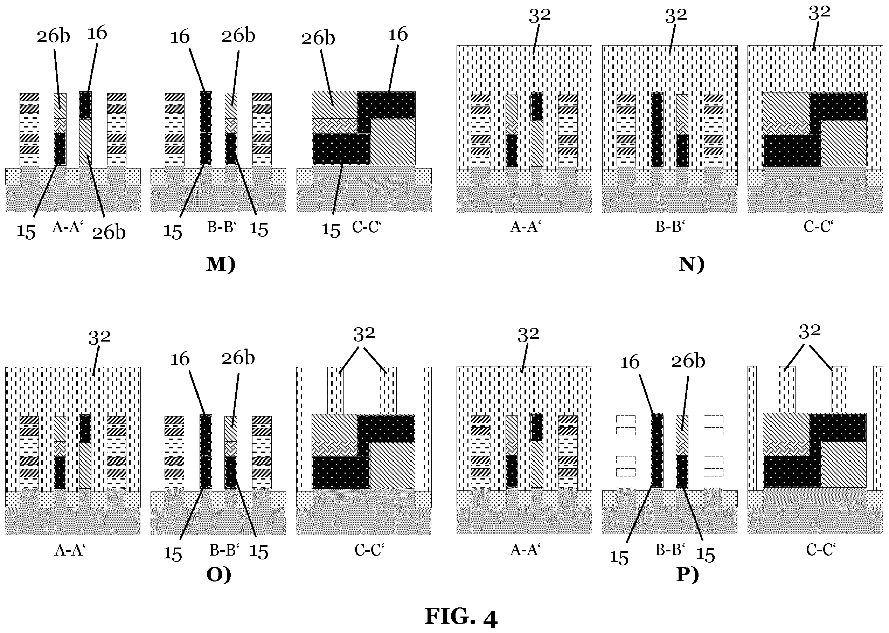

In a subsequent step, the buffer layer 25 can be recessed and the fin structure(s) 23 and side rail structure(s) can be revealed, as shown in FIG. 4M. Then, a dummy gate material 32, e.g. aSi (amorphous silicon) can be deposited (FIG. 4N). This dummy gate can be subsequently patterned (FIG. 4O) and the source and drain regions can be formed (FIG. 4P), e.g. by selectively recessing the fin structures in the patterned areas.

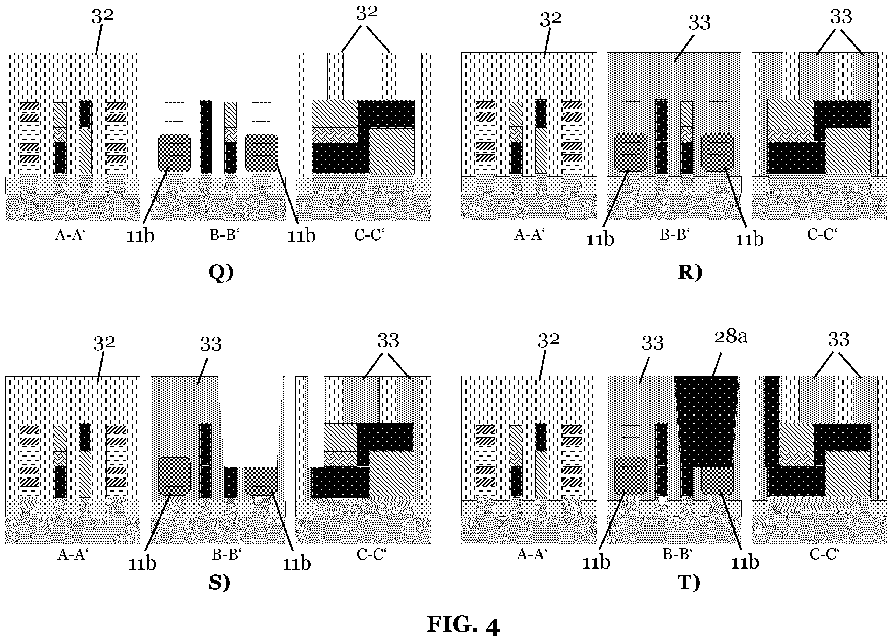

Then, the bottom source and/or drain terminal(s) 11b can be formed by means of an epitaxial growth process, as shown in FIG. 4Q, and an interlayer dielectric (ILDo) 33 can be deposited followed by a CMP step, as shown in FIG. 4R.

Subsequently, an MoAB patterning can be carried out by etching a trench to form a bridge between the first metal layer 15 (MoA) and the bottom side rail structure in the ILDo layer 33 and carrying out a metallization and CMP (FIGS. 4S and 4T). Then, a MoA metal recess can be carried out, as shown in FIG. 4U, to form the horizontal contact structure 28a. A vertical isolation 34a (bottom-up) can be formed on the horizontal contact structure 28a, as shown in FIG: 4V.

Then, the top source and/or drain terminal(s) 12b can be formed by means of an epitaxial growth process, as shown in FIG. 4W, and an interlayer dielectric (ILDo) 35 can be deposited followed by a CMP step, as shown in FIG. 4X.

The gate terminal(s) 11c material can then be deposited by an RMG (replacement gate metal) processing step (FIG. 4Y). Subsequently, the horizontal contact structure 28b which bridges the second metal layer with the second source or drain terminal 12b can be formed by an MoT patterning, e.g. by etching a trench to form a bridge between the second metal layer 16 (MoT) and the top side rail structure in the ILDo layer and carrying out a metallization, CMP and a metal recess (FIGS. 4Z and 4AA). A further plug layer 34b can then be formed on the horizontal contact structure 28b, as shown in FIG: 4BB.

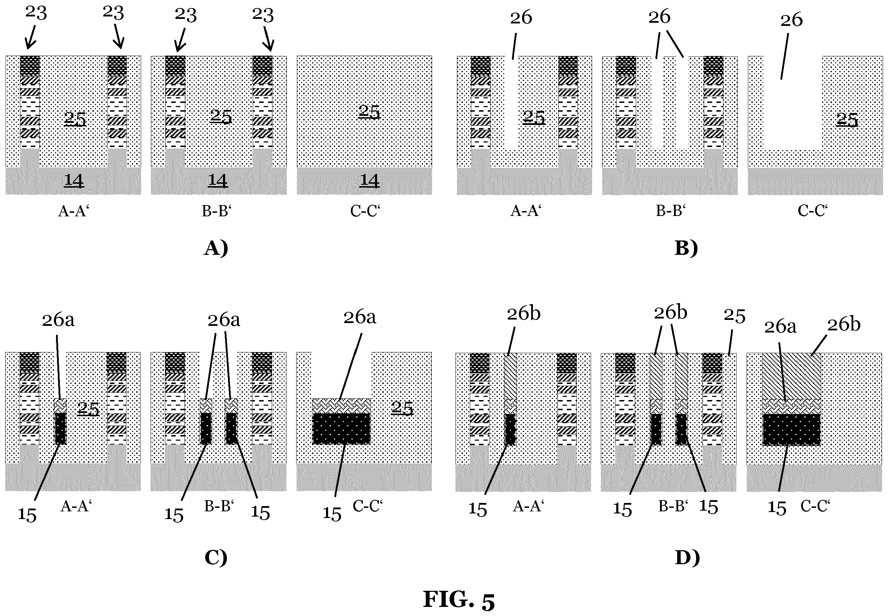

FIGS. 5A-H show a further process flow of the method for processing the CFET device according to an embodiment. In contrast to the process flow shown in FIGS. 4A-BB, no dummy fin structures 24 are used. Instead, the embedded side rail structure can be formed during STI module processing via lithographical etching.

As shown in FIGS. 5A and 5B, the first section of the trench 26 is directly etched in the buffer layer 26. This first section can then be filled by the first metal layer 15 (e.g., dielectric liner and metal liner or tungsten) and the vertical isolation 26a (FIG. 5C). Thereby, a CMP and/or metal recess can be carried out. Then, the remaining trench can be filled with an SiO₂ layer 26b and a CMP can be carried out (FIG. 5D).

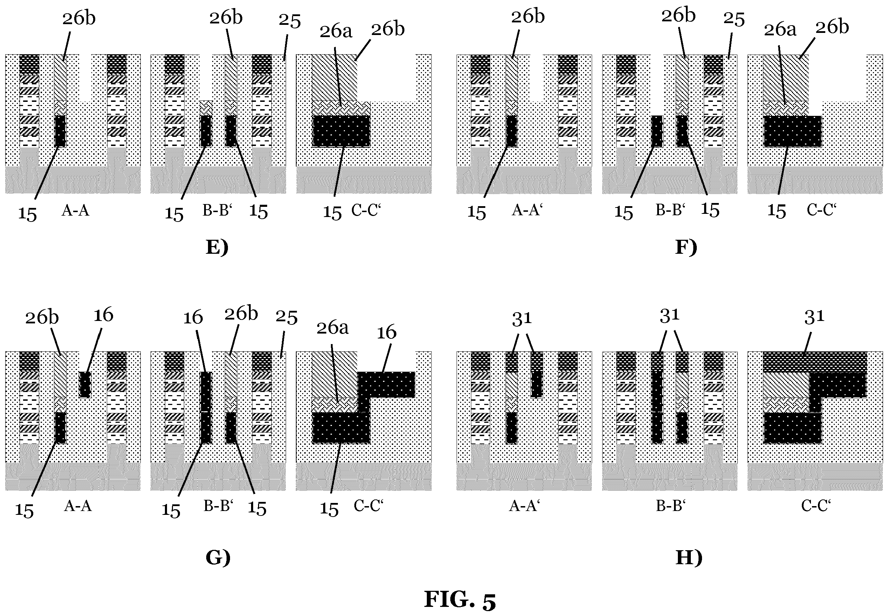

Subsequently, the second section of the trench 26 can be directly etched in the buffer layer 25, as shown in FIG. 5E, and a via recess can be formed in the vertical isolation 26a (e.g., by MoAT-MoAB patterning), as shown in FIG. 5F.

Then, the second metal layer 16 can be deposited in the via (via pre-fill) channel and the second section of the trench 26 to be at a level with the second layer stack 23b, as shown in FIG. 5G. This top side rail structure metallization can be followed by a metal recess.

In a following step, a recess of the SiO₂ layer 26b can be carried out and a Si₃N₄ plug 31 can be formed in the remaining section of the trench 26. A CMP step can further be carried out (FIG. 5H). The following processing steps can be identical to the steps shown in FIGS. 4M -BB.

Besides the above mentioned advantages and effects, the method as shown in any one of FIGS. 1A-F, FIGS. 4A-BB and FIGS. 5A-H can further provide the following advantages:
- No lateral side wall epi contact is required on the bottom source and/or drain terminals 11b. Instead, the MoAB contact for epi & embedded bottom side rail metal line can be formed simultaneously.
- The horizontal contact structures 28a, 28b can have a large contact surface with the source or drain terminals 11b, 12b, which reduces a contact resistivity.
- Damage to top epi (second source or drain terminal 12b) and vertical isolation as well as bottom MoA metal contact can be avoided, which could occur during a side rail routing patterning with a metal gate cut process (which is carried out post RMG).
- 2D lithographical patterning can be avoided and all side rail routing (1D) can be done during active patterning or during STI module. Perpendicular lithographic patterning can be done by extending the existing MoAB & MoAT (first and second level) lithography.
- The embedded side rail routing can be compatible with an RMG middle CFET integration scheme.

In addition, using the dummy fin structures 24 facilitates self-aligning the side rail metal (1D) patterning. Alternatively, the 2x litho-etch (non-self-aligned) approach shown in FIGS. 5A-H can be used to form the embedded side rail structure. In particular, the embedded side rail interconnect approach is compatible with a front-up monolithic CFET RMG-middle integration scheme.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A method for processing a complementary field effect transistor, CFET, device (10), comprising the steps of:
forming a fin structure (23) comprising a first layer stack (23a) and a second layer stack (23b) above the first layer stack (23a);
forming a trench (26) in a buffer layer (25) on one side of the fin structure (23), wherein the trench runs (26) in parallel to the fin structure (23);
filling a first section of the trench (26) at least partially with a first metal layer (15), wherein the first metal layer (15) is arranged at a level of the first layer stack (23a); and
filling a second section of the trench (26) at least partially with a second metal layer (16), wherein the second metal layer (16) is arranged at a level of the second layer stack (23b);
wherein the first metal layer (15) and the second metal layer (16) are arranged shifted to each other in a direction along the length of the trench (26).

2. The method of claim 1,
wherein the first layer (23a) stack comprises at least one channel (11a) of a first transistor structure of the CFET device (10), and wherein the second layer stack (23b) comprises at least one channel (12a) of a second transistor structure of the CFET device (10).

3. The method of claim 1 or 2, further comprising the step of:
forming a first horizontal contact structure (28a) which electrically connects the first metal layer (15) with a first source or drain terminal (11b) that is arranged on at least one side of the first layer stack (23a).

4. The method of claim 3,
wherein the first source or drain terminal (11b) is formed by means of an epitaxial growth process prior to the formation of the first horizontal contact structure (28a).

5. The method of claim 3 or 4,
wherein the first horizontal contact structure (28a) contacts the first source or drain terminal (11b) from the top.

6. The method of any one of the preceding claims, further comprising the step of:
forming a second horizontal contact structure (28b) which electrically connects the second metal layer (16) with a second source or drain terminal (12b) that is arranged on at least one side of the second layer stack (23b).

7. The method of claim 6,
wherein the second source or drain terminal (12b) is formed by means of an epitaxial growth process prior to the formation of the second horizontal contact structure (28b).

8. The method of claim 6 or 7,
wherein the second horizontal contact structure (28b) contacts the second source or drain terminal (12b) from the top.

9. The method of any one of the preceding claims,
wherein the trench (26) is formed by:
forming a dummy fin structure (24) next to the fin structure (23), wherein the dummy fin structure (24) runs in parallel to the fin structure (23);
filling an area on both sides of the dummy fin structure (24) with the buffer layer (26); and
at least partially removing the dummy fin structure (24).

10. The method of claim 9,
wherein, in a first removal step, a portion of the dummy fin structure (24) is removed to expose the first section of the trench (26); and, in a second removal step, a further portion of the dummy fin structure (24) is removed to expose the second section of the trench (26).

11. The method of claim 10,
wherein the first metal layer (15) is deposited in the first section of the trench (26) prior to the second removal step.

12. The method of any one of claims 1 to 8,
wherein the trench (26) is formed by etching into the buffer layer (25) with at least two separate etching steps;
wherein, in a first etching step, a portion of the buffer layer (25) is removed to expose the first section of the trench (26); and, in a second etching step, a further portion of the buffer layer (25) is removed to expose the second section of the trench (26).

13. The method of claim 12,
wherein the first metal layer (15) is deposited in the first section of the trench (26) prior to the second etching step.

14. The method of any one of the preceding claims, comprising the further step of:
forming a metal via structure (17) in the trench which electrically connects the first metal layer (15) with the second metal layer (16).

15. The method of any one of the preceding claims,
wherein the buffer layer (25) is a silicon dioxide, SiO₂, layer, in particular a FCVD SiO₂ layer.

16. A complementary field effect transistor, CFET, device (10) obtainable by the method according to any one of the preceding claims.
